# EUROPÄISCHE PATENTSCHRIFT

(11) **EP 2 659 749 B1**
(45) Veröffentlichungstag und Bekanntmachung des Hinweises auf die Patenterteilung: **09.09.2015**
(21) Anmeldenummer: 11802080.9
(22) Anmeldetag: 20.12.2011
(51) Int. Cl.: H05K 3/10, H05K 3/34, H05K 1/02, H05K 3/40

(54) **LEITERPLATTE, VERFAHREN ZUM HERSTELLEN EINER LEITERPLATTE UND PRÜFVORRICHTUNG ZUM PRÜFEN EINER LEITERPLATTE**
PRINTED CIRCUIT BOARD, METHOD FOR PRODUCING A PRINTED CIRCUIT BOARD AND TESTING DEVICE FOR TESTING A PRINTED CIRCUIT BOARD
CARTE DE CIRCUIT IMPRIMÉ, PROCÉDÉ DE FABRICATION DE LADITE CARTE DE CIRCUIT IMPRIMÉ ET DISPOSITIF DE CONTRÔLE PERMETTANT DE CONTRÔLER LA CARTE DE CIRCUIT IMPRIMÉ

(30) Priorität: 28.12.2010 DE 102010064261; 15.02.2011 DE 102011004106
(43) Veröffentlichungstag der Anmeldung: 06.11.2013
(73) Patentinhaber: Robert Bosch GmbH, 70442 Stuttgart (DE)
(72) Erfinder: NOWOTNICK, Jens, 72764 Reutlingen (DE); WAGENBRENNER, Walter, 71732 Tamm (DE); WARMBOLD, Ulrich, 31141 Hildesheim (DE); HEINEMANN, Sven, 38108 Braunschweig (DE); LAUSMANN, Matthias, 71711 Murr (DE); GEBHARDT, Holger, 38228 Salzgitter (DE); KLANTE, Bernhard, 38162 Cremlingen (DE)
(86) Internationale Anmeldenummer: PCT/EP2011/073363
(87) Internationale Veröffentlichungsnummer: WO 2012/089555

(56) Entgegenhaltungen:
- JP-A- 8 046 311
- US-A- 5 877 033
- US-A1- 2003 197 289
- US-A1- 2007 245 554
- US-A1- 2010 012 356

## Beschreibung

### Stand der Technik

Die Erfindung betrifft eine Anordnung zum Prüfen einer Leiterplatte nach dem Oberbegriff des Anspruchs 1.

Eine Leiterplatte nach dem Oberbegriff des Anspruchs 1 ist bereits aus der Praxis bekannt. Derartige Leiterplatten sind mit elektrischen bzw. elektronischen Bauteilen bestückt, die beispielsweise eine Schaltung eines Motorsteuergerätes ausbilden. Beim Fertigungsprozess der Leiterplatte bzw. nach dem Bestücken der Leiterplatte mit den elektrischen bzw. elektronischen Bauteilen muss die Funktion der Leiterplatte bzw. der Schaltung überprüft werden, um beispielsweise Fehlbestückungen oder Bauteildefekte ausschließen zu können. Dies erfolgt in der Praxis mittels stiftförmiger Prüfköpfe, die die Leiterplatte im Bereich von Prüfzonen elektrisch kontaktieren, um damit beispielsweise Widerstände zwischen bestimmten Stellen der Schaltung oder ähnliches prüfen zu können. Diese Prüfzonen werden durch Bereiche der Leiterbahnen gebildet, in denen, im Gegensatz zu anderen Bereichen der Leiterbahnen, die nur der Stromführung dienen, zuvor keine Schutzschicht in Form eines Lötstopplackes auf Leiterbahn aufgebracht wurde. Weiterhin ist die Prüfzone mit einer Lötmittelschicht versehen, um eine gute elektrische Kontaktierung der Prüfzone mit einem erwähnten stiftförmigen Prüfkopf zu gewährleisten.

Bei den in der Praxis bekannten Leiterplatten ist im Bereich der Prüfzone über die gesamte Breite der Leiterbahn kein Lötstopplack aufgebracht. Ferner überdeckt die Lötmittelschicht die gesamte Breite der Prüfzone. Problematisch dabei ist, dass die Lötmittelschicht dabei bis in einen Bereich außerhalb der Leiterbahn vordringen kann. Dies ist besonders dann problematisch, wenn aufgrund der üblicherweise geringen Abstände der Leiterbahnen es nicht ausgeschlossen werden kann, dass die Lötmittelschicht in den Bereich einer neben der Prüfzone liegenden Leiterbahn gelangt, so dass es zu elektrischen Kurzschlüssen kommen kann. Gerade die Tendenz zu immer geringer werdenden Abständen zwischen den Leiterbahnen, die erforderlich sind, um höhere Schaltungsdichten zu erzielen, erfordern daher viel engere Toleranzen bzgl. der Aufbringung der Lötmittelschicht sowie strengere Qualitätskontrollen zur Überprüfung auf nicht vorhandene Kurzschlüsse mit zur Prüfzone benachbarten Leiterbahnen, beides Maßnahmen, die die Fertigung einer Leiterplatte mit zusätzlichen Kosten belasten.

Aus der Offenlegungsschrift US2003/197289 (vergl. dem Oberbegriff des Anspruchs 1) sind Leiterplatten bekannt, welche Prüfzonen zur Überprüfung der Leiterplatte auf ihre fehlerfrei Funktionsfähigkeit aufweisen. Die Prüfzonen sind auf Abschnitten von auf der Oberfläche der Leiterplatte angeordneten Leiterbahnen ausgebildet. Die Oberfläche der Leiterplatte ist mit einer Schutzschicht versehen. Diese ist im Bereich der Prüfzonen derart geöffnet, dass die Prüfzonen zur Überprüfung der Leiterplatte kontaktiert werden können. Die Schutzschicht überdeckt einen Randbereich der Prüfzonen.

Die Offenlegungsschrift US2010/012356 zeigt einen Prüfvorgang einer Leiterplatte. Hierzu werden auf der Leiterplatte ausgebildete Prüfzonen mittels eines Prüfkopfes bzw. einer Prüfvorrichtung elektrisch kontaktiert. Die Prüfvorrichtung ist in Art einer Prüfnadel aufsgebildet.

Bekannt sind aus der Patentschrift US5877033 Prüfzonen in Leiterplatten, wobei die Prüfzonen eine beliebige Form hinsichtlich der Grundfläche aufweisen können. Die Prüfzonen sind vorzugsweise mit einer Lotmittelschicht beschichtet. Eine Schutzschicht auf der Oberfläche der Leiterplatte ist nicht offenbart.

Aus der Offenlegungsschrift US2007/245554 ist einer Ausführung einer elektrischen Verbindung einer Leiterplatte mit elektronischen Bauelementen offenbart. Zur Verbindung weist die Leiterplatte Kontaktierungsstellen auf, welche eine die Leiterplatte überdeckende Polymerschicht überragen. Nicht gezeigt ist die Möglichkeit einer Prüfung der Leiterplatte.

### Offenbarung der Erfindung

Ausgehend von dem dargestellten Stand der Technik liegt der Erfindung die Aufgabe zugrunde, eine Anordnung zur Prüfung einer Leiterplatte nach dem Oberbegriff des Anspruchs 1 derart weiterzubilden, dass einerseits eine sichere Prüfung der Schaltung im Bereich der Prüfzone durch den Prüfkopf ermöglicht wird, und dass andererseits gleichzeitig vermieden wird, dass die Lötmittelschicht auf neben der Prüfzone benachbarte Bereich der Leiterplatte, insbesondere auf benachbarte Leiterbahnen, gelangt. Diese Aufgabe wird bei einer Anordnung einer Leiterplatte mit den Merkmalen des Anspruchs 1 gelöst. Der Erfindung liegt dabei die Idee zugrunde, zwischen dem Kontaktbereich, der als der Bereich in der Prüfzone gilt, in der kein Lötstopplack angeordnet ist, und den Rändern der Leiterbahn im Bereich der Prüfzone einen Zwischenraum auszubilden. In diesem Zwischenraum ist der angesprochene Lötstopplack angeordnet. Dadurch ist sichergestellt, dass die Lötmittelschicht, selbst wenn diese in einen Bereich außerhalb des Kontaktbereichs gerät, den Bereich der Leiterbahn im Bereich der Prüfzone nicht überschreitet und somit auch nicht in den Bereich benachbarter Leiterbahnen gelangen kann. Mit anderen Worten gesagt bedeutet dies, dass die Größe der (lötstopplackfreien) Kontaktzone derart an die Größe der Prüfzone angepasst ist, dass die Kontaktzone mit Abstand innerhalb der Prüfzone angeordnet ist.

Um trotz der Schutzschicht eine sichere Kontaktierung des Prüfelements in der Kontaktzone zu ermöglichen, ist es erfindungsgemäß darüber hinaus vorgesehen, dass die Lötmittelschicht eine Erhebung ausbildet, die die Schutzschicht der Leiterplatte in der Höhe überragt.

Durch die letztgenannte Ausbildung der Lötmittelschicht ist es auch möglich, dass die Prüfzone seitlich zu wenigstens einer anderen Leiterbahn einen Abstand aufweist, der kleiner als der Durchmesser bzw. der Radius des Prüfelements ist, so dass bei auf der Kontaktzone aufgesetztem Prüfelement die andere Leiterbahn vom Prüfelement überdeckt ist, wobei das Prüfelement die andere Leiterbahn elektrisch nicht kontaktiert. Dadurch lassen sich sehr enge Anordnungen der Leiterbahnen realisieren, deren Abstände lediglich von den Fertigungstoleranzen bei der Herstellung der Leiterplatte bestimmt werden, jedoch nicht von der Anwesenheit bzw. der Dimensionierung eines Prüfelements.

Vorteilhafte Weiterbildungen der erfindungsgemäßen Leiterplatte sind in den Unteransprüchen angegeben. In den Rahmen der Erfindung fallen sämtliche Kombinationen aus zumindest zwei von in den Ansprüchen, der Beschreibung und/oder den Figuren offenbarten Merkmalen.

Um insgesamt gesehen möglichst schmale Leiterbahnen auf der Leiterplatte ausbilden zu können, damit sich eine hohe Bauteiledichte erzielen lässt, und andererseits eine sichere Kontaktierung des insbesondere als stiftförmigen Prüfkopfs ausgebildeten Prüfelements im Bereich der Prüfzone zu ermöglichen, ist es in einer besonders bevorzugten Ausgestaltung der Erfindung vorgesehen, dass die Leiterbahn im Bereich der Prüfzone eine Breite aufweist, die größer ist als die Breite der Leiterbahn außerhalb der Prüfzone.

In einer Ausführungsform, die sich besonders gut herstellen lässt, wird dabei vorgeschlagen, dass die Prüfzone und der von der Schutzschicht befreite Kontaktbereich jeweils im Wesentlichen rechteckförmig ausgebildet sind.

Als in der Praxis erprobte geometrische Dimensionierung der Kontaktzone zur Kontaktierung mit dem Prüfelement hat sich herausgestellt, wenn dieser einer Breite von 0,3mm und eine Länge von 0,5mm aufweist. Für die Prüfzone haben sich dabei als vorteilhaft eine Breite von 0,45mm und eine Länge von 0,65mm erwiesen.

Bekannt ist ein Verfahren zum Herstellen einer Leiterplatte. Hierbei ist es vorgesehen, dass an einer Oberfläche der Leiterplatte Leiterbahnen mit wenigstens einer Prüfzone ausgebildet werden, dass anschließend die Oberfläche der Leiterplatte mit einer Schutzschicht, insbesondere in Form eines Lötstopplacks, versehen wird, wobei zumindest im Bereich der Kontaktzone kein Lötstopplack aufgebracht wird, und wobei die Kontaktzone mit zumindest bereichsweise seitlichem Abstand innerhalb der von der Leiterbahn ausgebildeten Prüfzone angeordnet wird. Ein derartiges Freilassen der Prüfzone von der Schutzmittelschicht erfolgt dabei z.B. mittels einer entsprechenden Maske, die die Kontaktzone abdeckt. Insbesondere ist es dadurch auch nicht erforderlich, die Prüfzone bzw. die Kontaktzone erst nachträglich von der Schutzschicht bzw. dem Lötstopplack zu befreien.

Zur sicheren elektrischen Kontaktierung der Leiterbahn mit dem Prüfelement ist es darüber hinaus vorgesehen, dass nach dem Aufbringen der Schutzschicht im Bereich der Kontaktzone eine Lötmittelschicht aufgebracht wird.

Bekannt ist weiterhin eine Prüfvorrichtung zum Prüfen einer erfindungsgemäßen Leiterplatte. Hierbei ist es ganz besonders bevorzugt vorgesehen, dass die Prüfvorrichtung einen Prüfkopf aufweist, der in dem mit der Kontaktzone in Anlage kommenden Bereich im Querschnitt sternförmig mit Rippen ausgebildet ist. Ein derartig ausgebildeter Prüfkopf ermöglicht eine besonders sichere Kontaktierung der Kontaktzone, da sich die Rippen in die Lötmittelschicht gewissermaßen eingraben, so dass eine relativ große Kontaktfläche zwischen dem Prüfkopf und der Lötmittelschicht bzw. der Leiterbahn erzielt wird.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine Leiterplatte einer erfindungsgemäßen Anordnung im Bereich einer Prüfzone vor dem Aufbringen einer Schutzschicht in Form eines Lötstopplacks in Draufsicht,
- Fig. 2: die Leiterplatte gemäß Fig. 1 nach dem Aufbringen des Lötstopplacks, wobei ein Kontaktbereich, der mit einer Prüfvorrichtung zusammenwirkt, frei von Lötstopplack ist, ebenfalls in Draufsicht und
- Fig. 3: die Leiterplatte gemäß den Fig. 1 und 2 nach dem Aufbringen einer Lötmittelschicht während eines Prüfbetriebs zur Kontrolle der eine Schaltung tragenden Leiterplatte, ebenfalls in Draufsicht.

Gleiche Bauteile bzw. Bauteile mit gleicher Funktion sind in den Figuren mit den gleichen Bezugsziffern versehen.

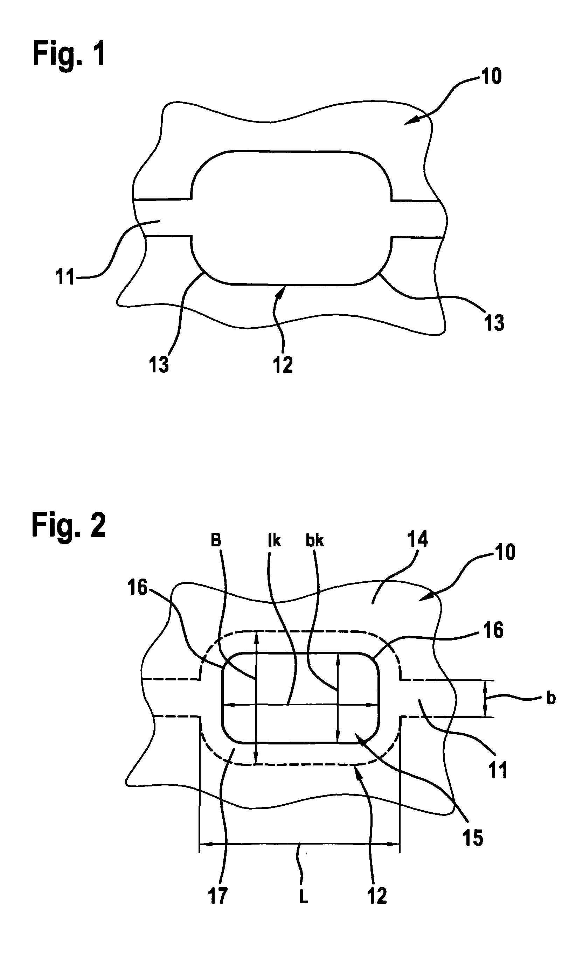

In den Fig. 1 und 2 ist beispielhaft die Oberseite einer Leiterplatte 10 im Bereich einer Leiterbahn 11 während des Herstellprozesses der Leiterplatte 10 dargestellt. Die Leiterplatte 10 ist hierbei insbesondere als Schaltungsträger für ein Steuergerät ausgebildet, wie es in der Kraftfahrzeugindustrie z.B. als Motorsteuergerät verwendet wird. Eine derartige Leiterplatte 10 ist weiterhin mit einer Vielzahl von in den Figuren nicht dargestellten elektrischen oder elektronischen Bauteilen bestückt bzw. elektrisch kontaktiert, die insgesamt gesehen eine Schaltung ausbilden.

Die Leiterbahn 11 weist normalerweise eine Breite b auf. Hingegen ist die Leiterbahn 11 in einer Prüfzone 12 der Leiterplatte 10 breiter ausgebildet, wobei sie eine Breite B von beispielsweise 0,45mm aufweist. Die Prüfzone 12 weist eine im Wesentlichen rechteckförmige Gestalt mit gerundet ausgebildeten Ecken 13 auf. Die Leiterbahn 11 besteht in üblicher Weise insbesondere aus Kupfer.

In der Fig. 2 ist der Zustand der Leiterplatte 10 im Bereich der Leiterbahn 11 zu einem späteren Produktionszeitpunkt dargestellt, wie dieser nach dem Aufbringen einer Schutzschicht 14, insbesondere in Form eines sogenannten Lötstopplackes, vorhanden ist. Der Lötstopplack hat hierbei die Funktion, die Oberfläche der Leiterbahnen 11 bzw. der Leiterplatte 10 abzudecken bzw. zu schützen, damit die Leiterbahnen 11 insbesondere nicht zur Korrosion neigen. Ferner dämmt der Lötstopplack die Benetzung der mit ihm überzogenen Oberflächen insbesondere durch Lötmittel ein bzw. verhindert diese, so dass Lötmittel im Wesentlichen nur in den dazu vorgesehene Bereichen der Leiterplatte 10 anhaftet, in denen kein Lötstopplack aufgebracht ist.

Erfindungswesentlich ist, dass innerhalb der Prüfzone 12 eine Kontaktzone 15 ausgebildet ist, in der keine Schutzschicht 14, das heißt kein Lötstopplack, vorhanden ist. Dies lässt sich in der Praxis mittels einer entsprechenden Maske realisieren, die die von Lötstopplack frei zu haltenden Zonen der Leiterplatte 10 abdeckt und somit verhindert, dass der entsprechende Kontaktbereich 15 mit der Schutzschicht 14 bzw. dem Lötstopplack benetzt wird.

Erfindungswesentlich ist weiterhin, dass die Kontaktzone 15 innerhalb der Prüfzone 12 angeordnet ist. Insbesondere ist es vorgesehen, dass die Kontaktzone 15 eine der Form der Prüfzone 12 angepasste Form aufweist, d.h. insbesondere ebenfalls rechteckförmig mit gerundeten Ecken 16 ausgebildet ist. Hierbei ist die Kontaktzone 15 vorzugsweise derart innerhalb der Prüfzone 12 positioniert bzw. ausgerichtet, dass sich zwischen der Kontaktzone 15 und den Randbereichen der Prüfzone 12 bzw. der Leiterbahn 11 ein gleichmäßig breiter Randstreifen 17 ergibt. Während die Länge L der Prüfzone 12 beispielhaft 0,65mm beträgt, beträgt die Länge Ik der Kontaktzone 15 zum Beispiel 0,5mm. Weiterhin beträgt die Breite bk der Kontaktzone 15 0,30mm. Die angegeben Maßangaben für die Prüfzone 11 und die Kontaktzone 15 haben sich hinsichtlich der Praxis insofern als vorteilhaft erwiesen, als dass diese Maße mit den fertigungstechnisch vorhandenen Toleranzen im Großserieneinsatz beherrschbar bzw. reproduzierbar sind. Wesentlich erscheinen jedoch auch die Längen- bzw. Breitenverhältnisse zwischen der Kontaktzone 15 und der Prüfzone 12, unabhängig vom jeweiligen Absolutmaß.

Nach dem Aufbringen der Schutzschicht 14 bzw. des Lötstopplacks auf die Oberfläche der Leiterplatte 10 bzw. dem Freilassen der Kontaktzone 15 von dem Lötstopplack wird die Kontaktzone 15 (sowie andere Bereiche der Leiterplatte 10 bzw. der Leiterbahnen 11, in denen die Leiterplatte 10 mit Bauelementen bestückt werden soll) mit einer Lötmittelschicht 18 versehen. Dies erfolgt, wie aus dem Stand der Technik bekannt, beispielsweise mittels einer Maske, die Aussparungen für die mit der Lötmittelschicht 18 zu versehenden Bereiche aufweist. In die Aussparungen der Maske wird Lötpaste eingegeben, beispielsweise mittels eines Rakels. Nach dem Entfernen der Maske wird die Leiterplatte 10 einer Reflow-Anlage zugeführt, so dass die Lötpaste sich in Form von Lötperlen ausbildet, die im Zusammenhang mit der Erfindung als Lötmittelschicht 18 bezeichnet werden.

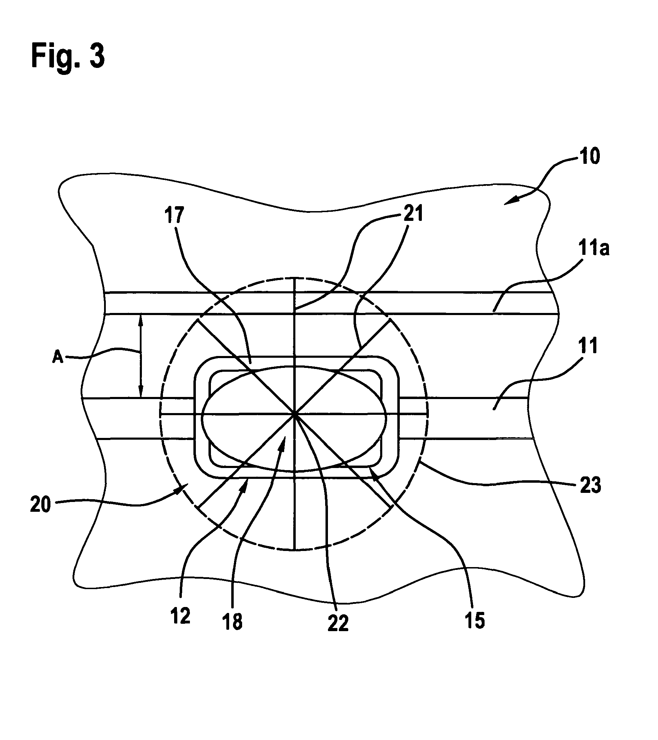

Die in der Fig. 3 dargestellte Lötmittelschicht 18 ist dabei als dreidimensionale Erhebung ausgebildet. Vorzugsweise wird versucht, die Lötmittelschicht 18 genau zu der Kontaktzone 15 bzw. zur Prüfzone 12 auszurichten. Durch die lötstopplackfreie Kontaktzone 15 ist dabei sichergestellt, dass die Lötmittelschicht 18 nur im Bereich der Kontaktzone 15 anhaftet. Sollte es, wie in der Fig. 3 dargestellt, zu einem Übertreten der Lötmittelschicht 18 über die Kontaktzone 15 hinaus kommen, so erreicht die Lötmittelschicht 18 jedoch maximal den Rand der Prüfzone 12, übertritt diesen aufgrund der Dimensionierung der Prüfzone 12 bzw. der Kontaktzone 15 jedoch nicht.

Weiterhin ist in der Fig. 3 eine zweite Leiterbahn 11a dargestellt. Diese Leiterbahn 11a ist in einem Abstand A zur Leiterbahn 11 angeordnet. Aus der Fig. 3 ist auch der Umriss eines Prüfelements 20 erkennbar, das vorzugsweise als Prüfkopf ausgebildet ist. Der Prüfkopf bzw. das Prüfelement 20 ist mit einer nicht dargestellten Kontrolleinrichtung sowie mit der Prüfzone 12, insbesondere mit der Lötmittelschicht 18 in der Kontaktzone 15, elektrisch verbunden. Dies wird durch ein Absenken des Prüfelements 20 auf die Lötmittelschicht 18 erzielt. Das Prüfelement 20 weist bevorzugt auf der der Lötmittelschicht 18 zugewandten Seite eine Vielzahl von Rippen 21 auf, die sternförmig zueinander um einen Mittelpunkt 22 angeordnet sind. Ferner erkennt man anhand der Fig. 3, dass der äußere Umriss des Prüfelements 20, der durch die gestrichelte Linie 23 bezeichnet ist, in Überdeckung mit der Leiterbahn 11a angeordnet ist. Es findet trotzdem keine elektrische Kontaktierung der Leiterbahn 11a durch das Prüfelement 20 statt, da die Lötmittelschicht 18 eine derartige Höhe bzw. Dicke aufweist, dass das (abgesenkte) Prüfelement 20 die Leiterbahn 11a dabei nicht kontaktiert. Der Abstand A kann somit kleiner gewählt werden als der Durchmesser bzw. der Radius des Prüfelements 20.

Die soweit beschriebene Leiterplatte 10 einer erfindungsgemäßen Anordnung kann in vielfältiger Art und Weise abgewandelt bzw. modifiziert werden, ohne vom Erfindungsgedanken abzuweichen. Dieser besteht in dem Vorsehen bzw. Ausbilden einer Kontaktzone 15, deren Größe derart bemessen ist, dass diese innerhalb einer Prüfzone 12 liegt, wobei zwischen der Kontaktzone 15 und den Rändern der Prüfzone 12 eine Schutzschicht 14 angeordnet ist.

## Patentansprüche

1. Anordnung zum Prüfen einer Leiterplatte (10), umfassend ein Prüfelement (20), das in elektrisch leitendem Kontakt mit einer Prüfzone (12) der Leiterplatte (10) gebracht werden kann, und eine Leiterplatte, wobei die Leiterplatte (10) zumindest an einer Oberfläche der Leiterplatte (10) angeordnete Leiterbahnen (11, 11a) aufweist, die zur elektrischen Kontaktierung von Bauelementen dienen, wobei die Prüfzone (12) von einem Abschnitt der Leiterbahn (11) gebildet wird, wobei die Oberfläche der Leiterplatte (10) mit einer insbesondere als Lötstopplack ausgebildeten Schutzschicht (14) versehen ist, die in der Prüfzone (12) im Bereich einer Kontaktzone (15) für das Prüfelement (20) unterbrochen ausgebildet ist, wobei die Kontaktzone (15) mit einer Schicht (18) versehen ist, die eine elektrische Kontaktierung des Prüfelements (20) mit der Schicht (18) ausbildet, und wobei die Kontaktzone (15) zumindest teilweise mit seitlichem Abstand zu den Rändern der Leiterbahn (11) im Bereich der Prüfzone (12) angeordnet ist,
**dadurch gekennzeichnet,**
**dass** die Schicht (18) eine Erhebung ausbildet, die die Schutzschicht (14) der Leiterplatte (10) in der Höhe überragt, und dass die Prüfzone (12) seitlich zu wenigstens einer anderen Leiterbahn (11a) einen Abstand (A) aufweist, der kleiner ist als der Durchmesser bzw. der Radius des Prüfelements (20), so dass bei dem auf der Kontaktzone (15) aufgesetzten Prüfelement (20) die andere Leiterbahn (11a) vom Prüfelement (20) überdeckt ist, wobei das Prüfelement (20) die andere Leiterbahn (11a) elektrisch nicht kontaktiert.

2. Anordnung nach Anspruch 1,
**dadurch gekennzeichnet,**
**dass** die Leiterbahn (11) im Bereich der Prüfzone (12) eine Breite (B) aufweist, die größer ist als die Breite (b) der Leiterbahn (11) außerhalb der Prüfzone (12).

3. Anordnung nach Anspruch 1 oder 2,
**dadurch gekennzeichnet,**
**dass** die Prüfzone (12) und die von der Schutzschicht (14) befreite Kontaktzone (15) im Wesentlichen rechteckförmig ausgebildet sind.

4. Anordnung nach Anspruch 3,
**dadurch gekennzeichnet,**
**dass** die Kontaktzone (15) eine Breite (bk) von 0,30mm und eine Länge (lk) von 0,50mm und die Prüfzone (12) eine Breite (B) von 0,45mm und eine Länge (L) von 0,65mm aufweist.

5. Anordnung nach einem der Ansprüche 1 bis 4,
**dadurch gekennzeichnet,**
**dass** das Prüfelement (20) einen Prüfkopf aufweist, der in dem mit der Kontaktzone (15) der Leiterplatte (10) in Anlage kommenden Bereich im Querschnitt sternförmig mit Rippen (21) ausgebildet ist.

## Claims

1. Arrangement for testing a printed circuit board (10), comprising a testing element (20) which can be brought into electrically conducting contact with a test zone (12) of the printed circuit board (10), and a printed circuit board, wherein the printed circuit board (10) has printed circuit tracks (11, 11a) which are arranged on at least one surface of the printed circuit board (10) and are used to make electrical contact with components, wherein the test zone (12) is formed by a section of the printed circuit track (11), wherein the surface of the printed circuit board (10) is provided with a protective layer (14), in particular in the form of solder resist varnish, which is interrupted in the test zone (12) in the region of a contact zone (15) for the testing element (20), wherein the contact zone (15) is provided with a layer (18) which makes an electrical contact between the testing element (20) and the layer (18), and wherein the contact zone (15) is arranged at least partially with lateral spacing from the edges of the printed circuit track (11) in the region of the test zone (12),
**characterized in that**
the layer (18) forms an elevation which projects above the protective layer (14) of the printed circuit board (10) in an upward direction, and **in that** the test zone (12) has a lateral spacing (A) from at least one other printed circuit track (11a) which is less than the diameter or the radius of the testing element (20) so that, when the testing element (20) is placed on the contact zone (15), the other printed circuit track (11a) is covered by the testing element (20), wherein the testing element (20) does not make electrical contact with the other printed circuit track (11a).

2. Arrangement according to Claim 1,
**characterized in that**
the printed circuit track (11) has a width (B) in the region of the test zone (12) which is greater than the width (b) of the printed circuit track (11) outside the test zone (12).

3. Arrangement according to Claim 1 or 2,
**characterized in that**
the test zone (12) and the contact zone (15) which has been freed from the protective layer (14) are substantially rectangular in shape.

4. Arrangement according to Claim 3,
**characterized in that**
the contact zone (15) has a width (bk) of 0.30 mm and a length (lk) of 0.50 mm, and the test zone (12) has a width (B) of 0.45 mm and a length (L) of 0.65 mm.

5. Arrangement according to one of Claims 1 to 4,
**characterized in that**
the testing device (20) has a testing head which is designed in cross section in the form of a star with ribs (21) in the region which comes into contact with the contact zone (15) of the printed circuit board (10).

## Revendications

1. Dispositif de contrôle d'une carte de circuit imprimé (10), comprenant un élément de contrôle (20), qui peut être amené en contact électriquement conducteur avec une zone de contrôle (12) de la carte de circuit imprimé (10), et une carte de circuit imprimé, dans lequel la carte de circuit imprimé (10) présente des pistes conductrices (11, 11a) disposées au moins sur une surface de la carte de circuit imprimé (10), qui servent au contact électrique des composants, dans lequel la zone de contrôle (12) est formée par une portion de piste conductrice (11), dans lequel la surface de la carte de circuit imprimé (10) est pourvue d'une couche de protection (14) conçue notamment comme un vernis épargne, qui est réalisée de manière interrompue dans la zone de contrôle (12) au niveau d'une zone de contact (15) pour l'élément de contrôle (20), dans lequel la zone de contact (15) est pourvue d'une couche (18), qui réalise un contact électrique de l'élément de contrôle (20) avec la couche (18), et dans lequel la zone de contact (15) est disposée au moins partiellement avec un espacement latéral par rapport aux bords de la piste conductrice (11) au niveau de la zone de contrôle (12),
**caractérisé en ce que**
la couche (18) réalise une élévation, qui dépasse en hauteur la couche de protection (14) de la carte de circuit imprimé (10) et **en ce que** la zone de contrôle (12) présente latéralement à au moins une autre piste conductrice (11a) un espacement (A), qui est plus petit que le diamètre, respectivement le rayon de l'élément de contrôle (20), de sorte que lorsque l'élément de contrôle (20) est placé sur la zone de contact (15) l'autre piste conductrice (11a) est recouverte par l'élément de contrôle (20), dans lequel l'élément de contrôle (20) ne contacte pas électriquement l'autre piste conductrice (11a).

2. Dispositif selon la revendication 1,
**caractérisé en ce que**
la piste conductrice (11) présente au niveau de la zone de contrôle (12) une largeur (B), qui est plus grande sur la largeur (b) de la piste conductrice (11) à l'extérieur de la zone de contrôle (12).

3. Dispositif selon la revendication 1 ou 2,
**caractérisé en ce que**
la zone de contrôle (12) et la zone de contact (15) dépourvue de la couche de protection (14) sont conçues essentiellement en forme de rectangle.

4. Dispositif selon la revendication 3,
**caractérisé en ce que**
la zone de contact (15) présente une largeur (bk) de 0,30 mm et une longueur (lk) de 0,50 mm et la zone de contrôle (12) présente une largeur (B) de 0,45 mm et une longueur (L) de 0,65 mm.

5. Dispositif selon une des revendications 1 à 4,
**caractérisé en ce que**
l'élément de contrôle (20) présente une tête de contrôle, qui est réalisée avec des nervures (21) avec une section transversale en forme d'étoile dans la zone venant reposer sur la zone de contact (15) de la carte de circuit imprimé (10).
